Europäisches Patentamt

European Patent Office

Office européen des brevets

(11) Publication number: **0 350 259**
**A2**

# EUROPEAN PATENT APPLICATION

(21) Application number: **89306779.3**

(51) Int. Cl.⁴: **G03F 7/00**

(22) Date of filing: **04.07.89**

(30) Priority: 05.07.88. JP 89596/88 U
27.04.89 JP 49944/89 U
27.04.89 JP 49936/89 U
27.04.89 JP 49937/89 U
27.04.89 JP 49938/89 U
27.04.89 JP 49939/89 U
27.04.89 JP 49942/89 U

(43) Date of publication of application:
**10.01.90 Bulletin 90/02**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Horikiri, Keiichi c/o SEIKO**
**INSTRUMENTS INC.**
**31-1, Kameido, 6-chome Koto-ku**
**Tokyo(JP)**
Inventor: **Onda, Michiyasu c/o SEIKO**
**INSTRUMENTS INC.**
**31-1, Kameido, 6-chome Koto-ku**
**Tokyo(JP)**
Inventor: **Nakamura, Haruki c/o SEIKO**
**INSTRUMENTS INC.**
**31-1, Kameido, 6-chome Koto-ku**
**Tokyo(JP)**

(74) Representative: **Miller, Joseph et al**
**J. MILLER & CO. Lincoln House 296-302 High**
**Holborn**
**London WC1V 7JH(GB)**

(54) **Container for image-recording sheets.**

(57) A container (3) for holding image-recording sheets (1) used in an image-recording apparatus, the container (3) having side walls (3a) and a bottom wall (3b) defining a space (3c) for holding image-recording sheets (1) characterised in that the top of the container (3) is provided with protective sheet means (4) adapted to cover at least part of any said sheets (1) in said space (3c).

Fig.1

EP 0 350 259 A2

## CONTAINER FOR IMAGE-RECORDING SHEETS

The present invention relates to a container for image-recording sheets and to an image-recording apparatus, such as a colour hard copy machine, provided with such a container.

US-A-4,399,290, US-A-4,440,846 and GB-A-2,223,860 (Mead Corporation) describe an imaging system. According to this system, a photosensitive layer comprising microcapsules which contain a photosensitive composition in the internal phase is exposed image-wise to actinic radiation and subjected to a uniform rupturing force, whereby the microcapsules rupture and release the internal phase image-wise. An image-forming agent, such as a substantially colourless chromogenic material, is coated on an image recording sheet and is typically associated with the microcapsules such that, when the microcapsules rupture, the chromogenic material is able to react image-wise with a developer material and produce a colour image. Since this printing system can produce pixels of the same size as the size of a microcapsule, that is of the order of microns, a colour image is printed with extremely high resolution.

There are roughly two types of image-recording sheets in terms of their storage and feeding systems. One is provided in the form of a roll, such as that disclosed in the above U.S. Patents. The other is provided in the form of cut sheets. This cut sheet feed system is disclosed in, for example, EP-A-255,138. Cut-image recording sheets are generally provided in a large container box. Consequently, when cut image-recording sheets are placed in position at a feeding station or in a feed tray of an image-recording apparatus, a required number of cut image-recording sheets are taken out from a large container box and are thereafter placed in the feeding station by hand.

This manual operation can cause basically two problems. A front surface of a cut image-recording sheet is coated with an image-forming agent, and therefore manual handling of the cut image-recording sheets may well damage the image-forming agent coated surface of the image-recording sheet, since the image-forming agent can easily come off from the surface of the sheet. Furthermore, even though the front surface of an image-recording sheet is coated with an image-forming agent, the coating of the image-forming agent is not discernible, and therefore the front surface of the sheet coated with the image-forming agent is easily mistaken for its rear surface.

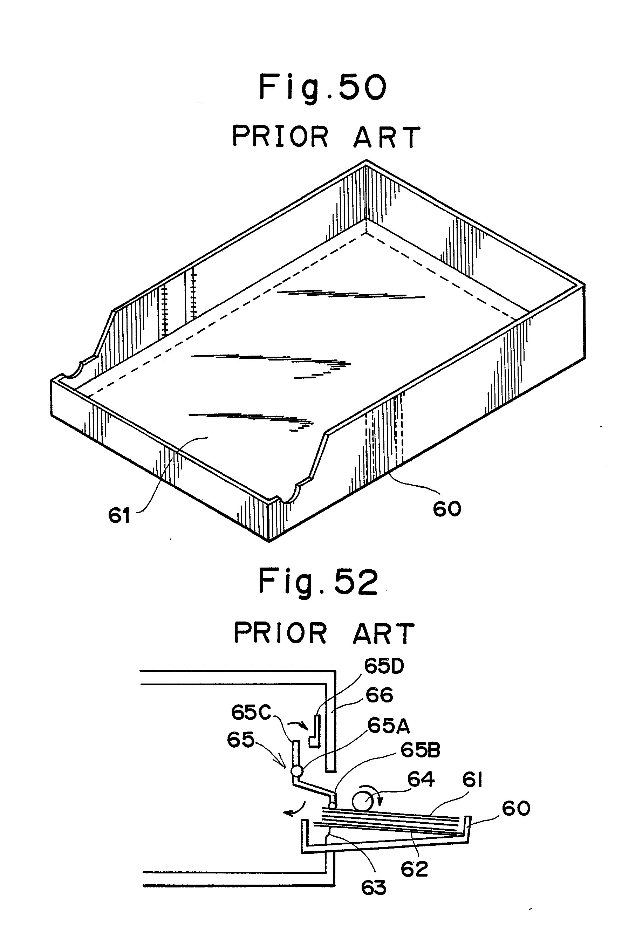

Secondly, a known feeding tray 60 is shown in Figure 50. A required number of image-forming sheets are placed in a feed tray 60 before the feed tray 60 is fitted into an image-forming apparatus, such as a colour hard copy machine. Such a feed tray may have brushes on the inner surfaces thereof in order to prevent simultaneous feeding of a plurality of image-forming sheets (hereafter referred to as double feeding). However, when image-recording sheets are used, such brushes are not desirable because the bristles of the brushes scrape off the image-forming agent coated on the surface of the image-forming sheet.

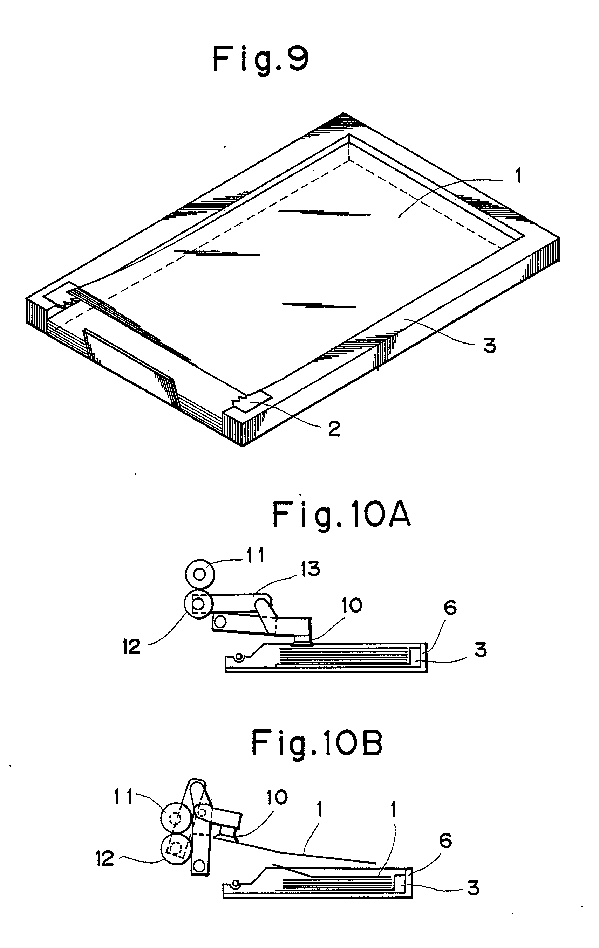

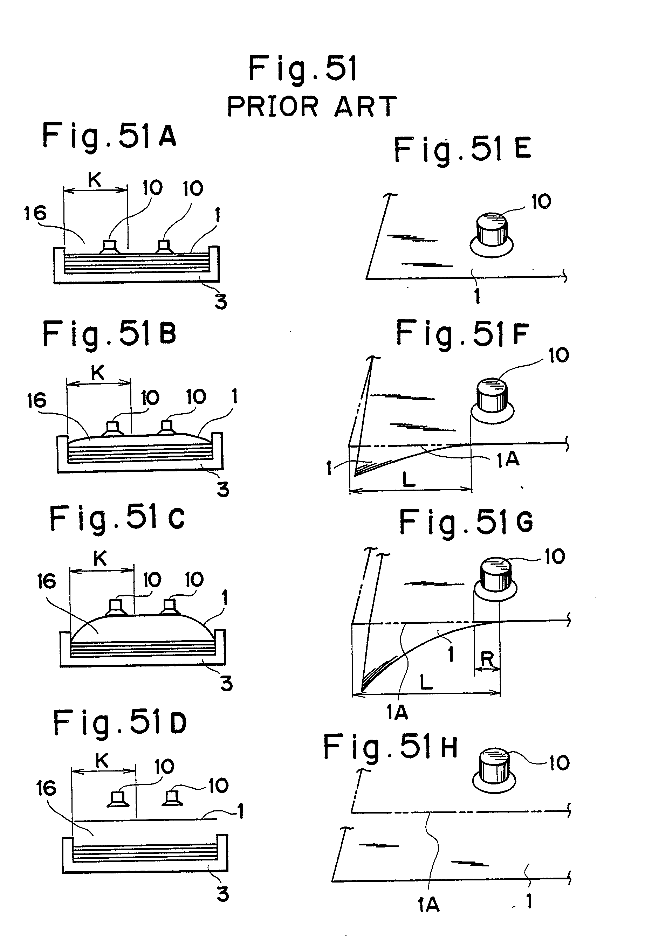

A known image-forming apparatus is provided with an image-recording sheet feeder such as that schematically shown in Figure 10A and Figure 10B. When this image-forming apparatus is provided with a feed tray such as shown in Figure 50, another problem occurs in addition to the problems described above. The image-recording sheet feeder basically uses the suction force of suckers for attracting an image-recording sheet. The attracted image-recording sheet is then fed into the image-forming apparatus. Figures 51(A) to 51(D) schematically show the operation of feeding an image-recording sheet 1 by means of suckers 10. Figures 51(E) to 51(H) are perspective views showing successively the operation of feeding the image-recording sheet 1 by the suckers 10. Figure 51(A) shows a state, in which the image-recording sheet 1 which is stored in a feed tray 3 has its surface sucked up by two suckers 10. Figure 51(E) is a perspective view showing the state of the image-recording sheet 1 which has been sucked up by the suckers 10 within the range of a sheet portion K shown in Figure 51(A). When the suckers 10 are slightly raised from the state shown in Figure 51-(A), the image-recording sheet 1 has its peripheral portion caught by the inner walls of the feed tray 3 due to the friction between the periphery of the image-recording sheet 1 and the inner walls of the feed tray 3 which arises because the image-recording sheet 1 and the storage space in the feed tray 3 have substantially the same shape. As a result, the peripheral portion of the image-recording sheet 1 does not rise as compared with the inner portion of the image-recording sheet as shown in Figure 51(B), which results in a curve L around the peripheral portion of the image-recording sheet 1. When the suckers 10 are raised to the height shown in Figure 51(C), the curve L extends to a position under the suckers 10 as shown in Figure 51(G) and the force of attraction between the suckers 10 and the image-recording sheet 1 is consequently reduced. When the suckers 10 are further raised, the force of attraction between the image-recording sheet 1 and the suckers 10 is lost, and consequently the image-recording sheet 1 drops back into the feed tray 3 as shown in Figures 51(D) and 51(H). In particular, when the humidity around the image-recording sheet 1 is high, the resistance of the image-forming agent coated on the image-recording sheet 1 is increased, whereby the problem described above becomes worse.

Thirdly, in the prior art, detection is performed by providing a detection unit in a sheet conveyor path inside the image-recording apparatus. In the prior art, attempts continue to be made to feed the sheets to the inside of the image-recording apparatus until the detection unit judges that the supply of sheets is exhausted, despite the fact that the sheets have already been exhausted. In order to prevent such a situation it has been suggested to provide a mechanism in the apparatus for moving up the sheets so that the existence of the sheets may be determined by a touch sensor. For example, Figure 52 is a schematic sectional view showing a paper feed unit of the prior art. Sheets 61 are packed in a feed tray 60 which is provided therein with a pop-up plate 62, the plate 62 being urged upwardly by the extension of a spring 63. Over the surface of the feed tray 60, there is arranged a roller 64, which is made of silicone rubber, for conveying the sheets 61 into an image-recording apparatus 66. At the end of the sheets 61, there is arranged a touch sensor 65 for detecting the existence of the sheets 61. The touch sensor 65 has two end portions 65B and 65C pivotally mounted on a fulcrum 65A so that, when all the sheets 61 are conveyed out of the feed tray 60, a detection member 65D comes into contact with the end portion 65C to inform the image-recording apparatus 66 itself or its user of the exhaustion of the sheets 61. Thus, the image-recording apparatus of the prior art cannot of itself recognize the exhaustion of the image-recording sheets, and continues its feeding and printing operations even in the absence of image recording sheets. Such operations, however, may damage components provided within the image-recording apparatus, such as suckers, pressure rollers, etc.

Fourthly, an image-recording apparatus of the prior art has a feeding station whose width is manually adjusted for accommodating image-recording sheets of different sizes. The change of sheet size is detected with a sheet-size detection unit provided within the image-recording apparatus, and the pressure of the pressure rollers is adjusted according to the detected change in size of the image-recording sheet. Therefore there is the likelihood of wrong feeding of an image-recording sheet of an inappropriate size. When an inappropriate sheet is fed, components such as pressure rollers provided within an image-recording apparatus may be damaged due to improper roller pressure for a fed image-recording sheet.

According to the present invention, there is provided a container for holding image-recording sheets used in an image-recording apparatus, the container having side walls and a bottom wall defining a space for holding image-recording sheets characterised in that the top of the container is provided with protective sheet means adapted to cover at least part of any said sheets in said space.

The protective sheet means are preferably adapted to protect any said sheets in said space from physical contact prior to use in the said apparatus, at least a part of the protective sheet means being readily removable from the container to permit any said sheets therein to be fed to the said apparatus.

Preferably, at least part of the protective sheet means can be peeled away from the container.

There are preferably means for assisting the said peeling away of the protective sheet means.

Thus the protective sheet means may have a portion which extends outwardly of the adjacent part of the container so as to assist the said peeling away of the protective sheet means.

If desired, the protective sheet means may be provided with a cut-out.

The protective sheet means may comprise a part which is adapted to be at least partially peeled away from the container and a part which is adapted to remain fixed to the container.

The top of the container may be provided with a removable protective sheet which overlies the protective sheet means and may be removed from the latter.

Preferably, a stack of image-recording sheets are housed in said space, each said sheet comprising a substrate coated with an image-forming agent which is reactive with a photosensitive material.

The container may be provided with means for preventing or reducing double feeding of image-recording sheets from the container.

Thus side walls of the container may have parts which are cut away with respect to other parts thereof so that corner portions of image-recording sheets in the said space do not engage said cut away parts.

The container may have sheet-engaging members therein to prevent engagement between at least part of side walls of the container and adjacent sides of the said sheets.

The container may be provided with indicating means for indicating the size of the image-recording sheets which it is adapted to hold.

The indicating means may comprise at least one recess or projection in a side wall of the container.

The invention also comprises an image-forming apparatus provided with the said container, feeding means being provided for feeding image-recording sheets from the container to the apparatus.

Recognition means may be provided for recognizing the presence or exhaustion and/or the size of image-recording sheets in the container. Such means may comprise a non-contact type sensor, e.g. a sensor responsive to light passing through a hole in the bottom wall of the container, or a contact type sensor such as a microswitch or a potentiometer.

The invention also provides a container for holding image-recording sheets used in an image-recording apparatus characterised in that the container is provided with means for preventing or reducing double feeding of image-recording sheets from the container.

Furthermore, the invention provides a container for holding image-recording sheets used in an image-recording apparatus characterised in that the container is provided with indicating means for indicating the size of the image-recording sheets which it is adapted to hold.

Moreover, the invention provides an image-forming apparatus characterised in that recognition means are provided for recognizing the presence or exhaustion and/or the size of image-recording sheets in the container.

The invention is illustrated, merely by way of example, in the accompanying drawings, in which:-

Figure 1 is a perspective view of a first embodiment of a container according to the present invention;

Figure 2 is a perspective view of a second embodiment of a container according to the present invention;

Figure 3 to Figure 6 are perspective views of containers according to the present invention having various means for preventing double feed;

Figure 7 is a perspective view of one embodiment of an image-recording sheet feeding tray for housing a container as shown in Figure 1 or Figure 2;

Figure 8 is a perspective view similar to that of Figure 7 but showing the said container in position in the sheet feeding tray;

Figure 9 is a perspective view of a container according to the present invention in use;

Figures 10A and 10B schematically show a container according to the present invention in the course of a feeding operation;

Figure 11 is a perspective view of a third embodiment of a container according to the present invention;

Figure 12 is a perspective view of a fourth embodiment of a container according to the present invention;

Figure 13 is a perspective view of a fifth embodiment of a container according to the present invention;

Figure 14 is a perspective view of a sixth embodiment of a container according to the present invention;

Figures 15A and 15B show a seventh embodiment of a container according to the present invention;

Figures 16A and 16B are perspective views of an eighth embodiment of a container according to the present invention;

Figure 16C is a perspective view of a ninth embodiment of a container according to the present invention;

Figures 17 and 18 show tenth and eleventh embodiments of a container according to the present invention;

Figures 19, 20 and 21 show twelfth, thirteenth and fourteenth embodiments of a container according to the present invention;

Figures 22, 23 and 24 show fifteenth, sixteenth and seventeeth embodiments of a container according to the present invention;

Figures 25A to 25H schematically successively illustrate the operation of feeding image-recording sheets from a container according to the present invention;

Figures 26 to 28 show various containers according to the present invention provided with corner recesses;

Figures 29 and 30 show further containers according to the present invention having cut away corner portions;

Figure 31 shows yet a further container according to the present invention provided with internal members engageable with sheets in the container;

Figure 32 is a schematic cross section of a feeding mechanism which may be provided with a container according to the present invention;

Figure 33 is a plan view of a container according to the present invention having size recognition recesses;

Figure 34 illustrates the relationship between recess combinations and sheet sizes of containers according to the present invention;

Figure 35 is a schematic circuit diagram of a sheet size recognition unit which may be used in association with a container according to the present invention;

Figure 36 is a perspective view of a container according to the present invention having size recognition members of a first type;

Figure 37 is a perspective view of a container according to the present invention having size recognition members of a second type;

Figure 38 is a perspective view of a container according to the present invention having size recognition members of a third type;

Figure 39 is a perspective view of a container according to the present invention having size recognition members of a fourth type;

Figures 40A and 40B are segmentary views showing recesses of different depths provided in a container according to the present invention;

Figure 41 is a schematic view of a feeding mechanism provided with the container shown in Figures 40A or 40B;

Figure 42 is a schematic view of a first embodiment of a feeding mechanism provided with a container according to the present invention having a sheet recognition hole provided therein;

Figure 43 is a schematic view of a second example of a feeding mechanism provided with a container according to the present invention having a sheet recognition hole provided therein;

Figure 44 is a schematic operation diagram of an image-recording sheet recognition unit;

Figure 45 is an enlarged cross section of a part of a container according to the present invention showing a sheet recognition hole therein;

Figure 46A is a perspective view of a container according to the present invention having a sheet recognition hole therein;

Figure 46B schematically shows the position of a sensor when sheets remain in a container according to the present invention;

Figure 46C schematically shows the position of the sensor when the sheets are exchausted;

Figure 47 schematically shows a feeding mechanism provided with a container according to the present invention having sheet and sheet size recognition holes;

Figure 48 is a perspective view of the back side of a container according to the present invention having sheet and sheet size recognition holes;

Figures 49A to 49D show variations of sheet and sheet size recognition holes;

Figure 50 is a perspective view of a known feeding tray;

Figures 51A to 51H schematically successively illustrate the operation of the feeding of image-recording sheets according to the prior art; and

Figure 52 schematically shows a feeding mechanism of the prior art.

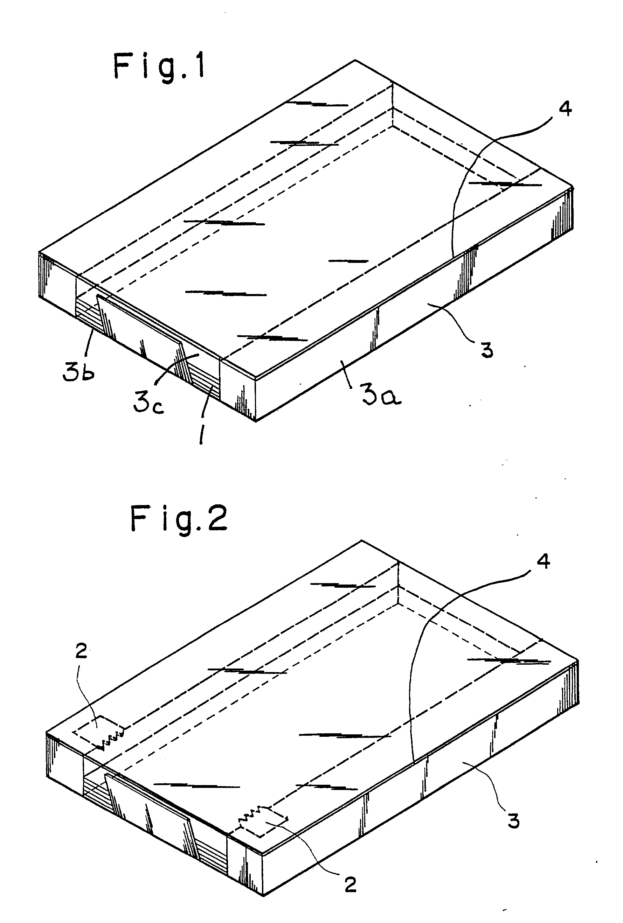

Figure 1 is a perspective view showing a container or packing case 3 constituting a first embodiment of the present invention. The container 3 has side walls 3a and a bottom wall 3b defining a space 3c for accommodating a stack of image-recording sheets 1. The latter may have a substrate coated with an image-forming agent which is reactive with a photosensitive material. The container 3 has an upper surface of its storage portion covered with a protective sheet 4 for covering the image-recording sheets 1 and thus protecting the image-forming agent on the image-recording sheets 1 from physical contact prior to use in an image-recording apparatus, and thus during transportation, handling and storage prior to such use. The protective sheet 4 can, however, be peeled off the container 3 so as to permit the sheets therein to be fed to the said apparatus. Moreover, as shown in Figure 2, the container 3 may also be provided with members 2 for preventing double feeding of the image sheets.

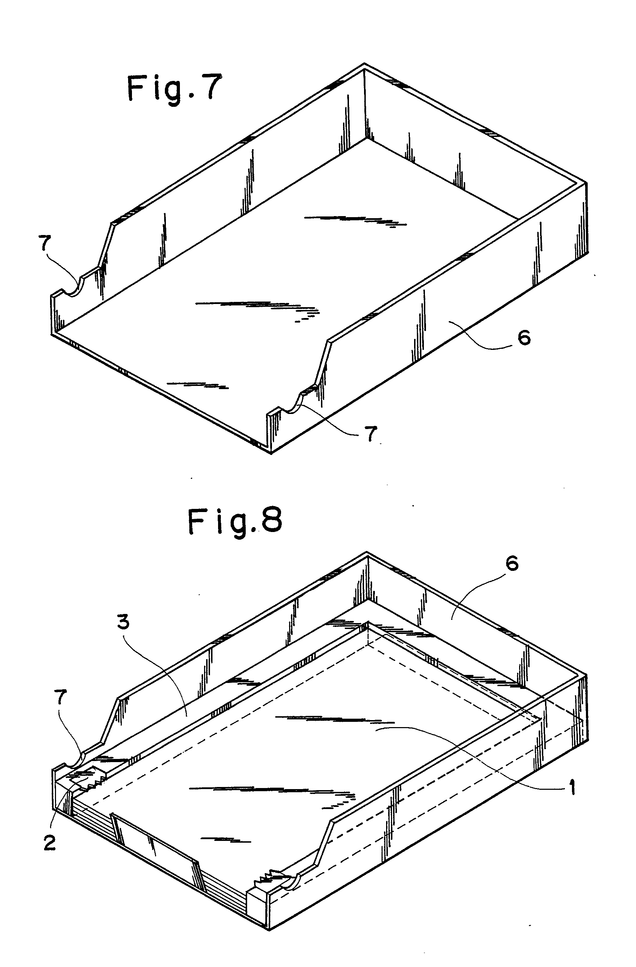

Figure 7 is a perspective view showing a paper feed tray 6 for receiving a container 3 and for feeding the image-recording sheets 1 from the container 3 and into the image-recording apparatus. The paper feed tray 6 is formed with cut-away portions 7.

There will now be described a method of feeding the image-recording sheets by using a container as described above. The container referred to in the following embodiments has been particularly designed to be used in a image-recording apparatus such as briefly described above. Such an image-recording apparatus is basically comprised of feeding means for feeding an image-recording sheet into an image-forming apparatus; illuminating means for illuminating an original image or information; and exposure means for exposing the image-recording sheet to light representative of the original image or information.

First, when the image-recording sheets 1 in the container 3 are exhausted, the paper feed tray 6 which houses the container 3 is removed from the image-recording apparatus. Then, the empty container 3 is taken out of the paper feed tray 6.

After this, as shown in Figure 8, a new container having a stack of image-recording sheets 1 therein is placed in the paper feed tray 6. The container 3 has its protective sheet 4 peeled off, before it is placed in the paper feed tray 6, so that the image-recording sheets 1 can be fed into the image-recording apparatus from the container 3, as shown in Figure 9.

The feed of the image-recording sheets 1 to the image-recording apparatus will now be described.

Figures 10A and 10B are schematic views showing paper feeding operations using the container 3 described above. The image-recording sheets 1 are housed in the container 3, which in turn is fitted in the paper feed tray 6. The paper feed tray 6 is mounted in the image-recording apparatus. The image-recording sheets 1 are fed into the image-recording apparatus by a paper feed device which is composed of paper feed rollers 11 and 12 for conveying the image-recording sheets 1 to the inside of the image-recording apparatus; a link mechanism 13 associated with the paper feed roller 11; and suckers 10 carried by the link mechanism 13 for sucking up the image-recording sheets 1.

First, as shown in Figure 10A, the suckers 10 carried by the link mechanism 13 are forced into suction contact with the surface of the uppermost image-recording sheet 1 as the paper feed roller 12 rotates. After this, as shown in Figure 10B, the suckers 10, having sucked up the uppermost image-recording sheet 1, are raised as a result of the rotation of the paper feed roller 12 to transfer the uppermost image-recording sheet 1 to the paper feed rollers 11 and 12. As the paper feed rollers 11 and 12 rotate, the image-recording sheet 1 is fed into the image-recording apparatus.

The protective sheet 4 covering the upper surface of the container 3 need not be removed throughout the whole surface area. For example, the protective sheet 4 may be made peelable from the container 3 only at a predetermined portion of the upper surface of the container 3 at the side of the paper feed device, but the remaining portion of the protective sheet 4 may be fixed to the container 3 by means of adhesion or fusion. When the container 3 is used, the protective sheet 4 is peeled off only at its peelable portion, and its peeled portion may be folded back to the remaining portion which is fixed to the container 3. Moreover, if the peelable portion of the protective sheet 4 is made to be capable of being repeatedly peeled and sealed by using a suitable glue, the once peeled portion can be sealed again. Then, the protective sheet 4 can again protect the image-recording sheets 1 when the container 3 is taken out of the image-recording apparatus before the image-recording sheets 1 are completely exhausted.

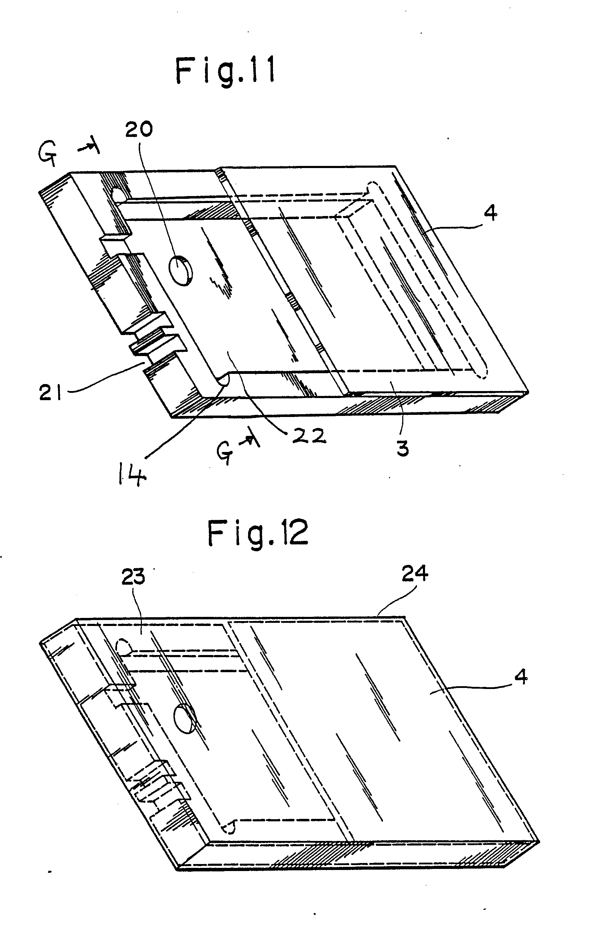

Figures 11 to 15B are perspective views showing containers constituting third, fourth, fifth, sixth and seventh embodiments of the present invention. Figure 11 is a perspective view showing a container 3, the storage portion of which has about one half of its upper surface covered by a protective cover 4. This protective cover 4 may be made of paper, fabric, synthetic resins or metallic material, and is glued or fused to the container 3. Double-dotted lines appearing in Figure 11 indicate an imaginary state in which the image-recording sheets 1 are housed in the storage portion of the container 3. A container 3, of the general construction shown in Figure 11, may be covered all over its surfaces with an overall protective sheet 24 as shown in the fourth embodiment of Figure 12. Before the container 3 is placed in the image-recording apparatus, the overall protective sheet 24 is removed and the image-recording sheets are exposed for sheet feeding operation as shown in Figure 11.

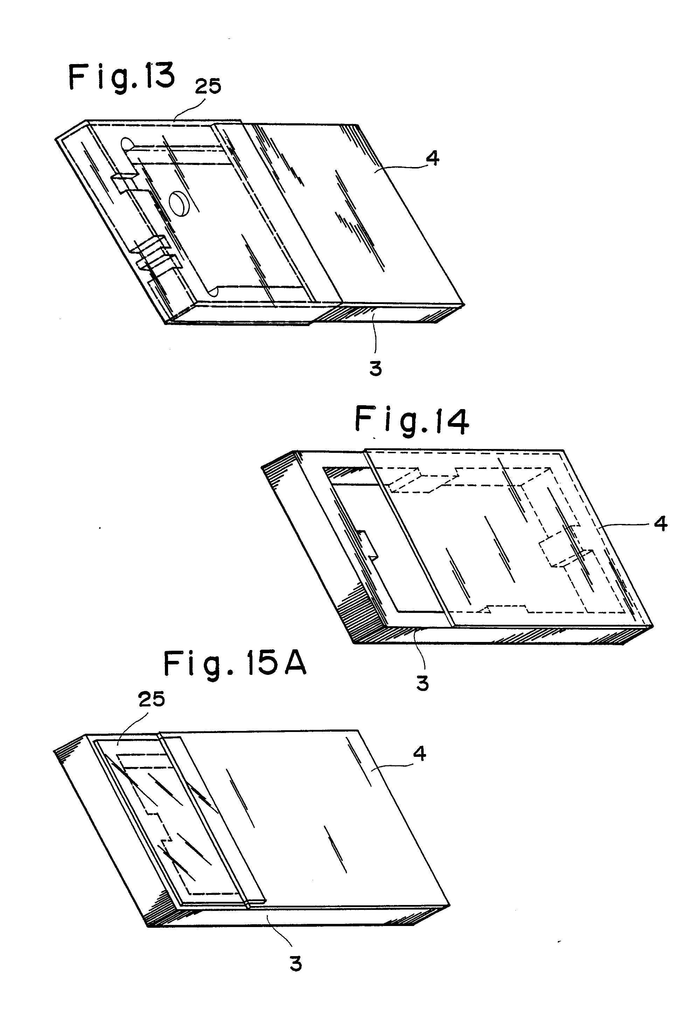

Of course the container 3 may not have to be covered all over its surfaces. For example, a partial protective sheet 25 covering only the opening in the container 3 is sufficient to protect the image-recording sheets 1, as shown in the fifth embodiment of Figure 13.

Figure 14 is a perspective view showing a sixth embodiment of a container 3 having its top surface covered by a protective cover 4 except for a minimum opening necessary for the paper feed mechanism to feed the image recording sheets 1.

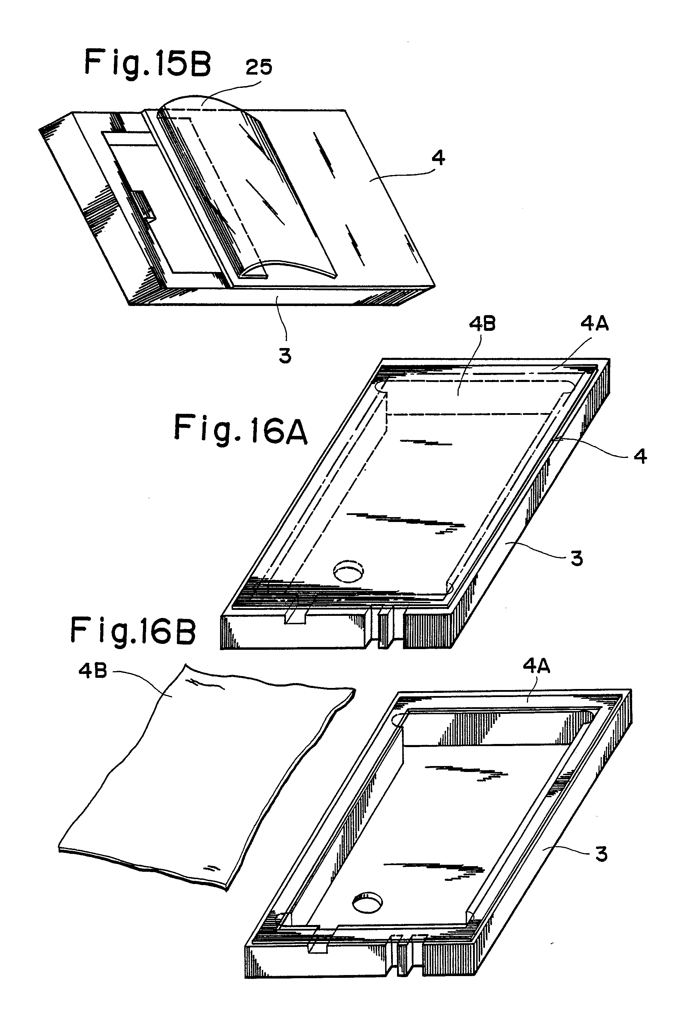

Figure 15A shows a seventh embodiment in which an opening protection sheet 25 is arranged to cover only the opening formed in the upper surface of the storage portion of the container 3 of Figure 14. The opening protection sheet 25 may be completely removed or may be peeled away until the opening is sufficiently uncovered for the feeding operation. In the case of the latter, as shown in Figure 15B, the peeled away portion of the opening protection sheet 25 is pulled backward while the container containing the image-recording sheets 1 is placed in the image-recording apparatus. By providing an appropriate adhesive between the opening protection sheet 25 and the container 3, the opening may be re-sealed when the container 3 is removed from the image-recording apparatus before all the image-recording sheets 1 are exhausted.

Figure 16A shows an eighth embodiment of the present invention in which a protective sheet 4 is arranged to cover the upper surface of the container 3 housing the image-recording sheets 1. The protective sheet 4 is provided with separation means such as perforations or separating tapes for separating a sheet fixing portion 4A and a sheet peeling portion 4B along single-dotted lines. By gluing or fusing the sheet fixing portion 4A to the container 3, the protective sheet 4 is arranged to cover the upper surface of the storage portion of the container 3. When such a container 3 is placed in the image-recording apparatus, the sheet peeling portion 4B is separated from the sheet fixing portion 4A so that the image-recording sheets 1 are exposed for the feeding operation, as shown in Figure 16B.

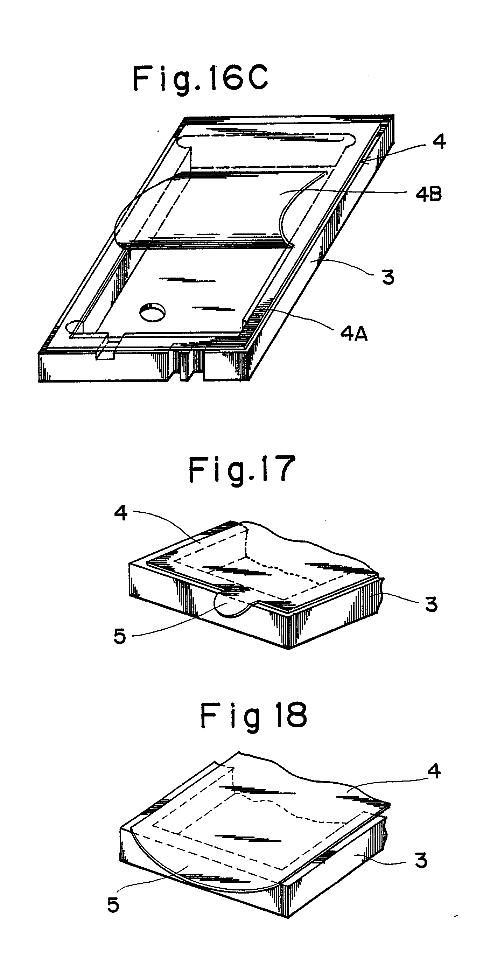

Alternatively, the aforementioned separation means may be disposed only at a part of the periphery around the storage portion of the container 3. Such a container is shown in perspective in Figure 16C. When the container 3 is placed in the image-recording apparatus, a sheet peeling portion 4B is removed from a sheet fixing portion 4A of a protective sheet 4 only at a part of the periphery around the storage portion of the container 3. It is no doubt possible to provide separation means of this type in the case of the aforementioned opening protection sheets of the containers of the third to seventh embodiments. The protective sheet 4 described in the foregoing not only protects the image-forming agent coated on the image-forming sheets from physical damage but also maintains a constant moisture level inside the container so that the image-forming sheets enclosed in the container can be maintained at an optimum quality.

Figures 17 and 18 are perspective views showing tenth and eleventh embodiments respectively provided with a protective sheet or an opening protection sheet.

As shown in Figure 17, a protective sheet 4 to be peeled from a container 3 is provided with an ear or a flap 5 protruding from a portion of one side of the container 3. As shown in Figure 18, on the other hand, a protective sheet 4 to be peeled from a container 3 is provided with a peeling aid flap 5 which protrudes from the whole length of one side of the container 3.

Thus, by forming the peeling aid flap 5 at the protective sheet or the opening protection sheet such that it extends from the container, the protective sheet and the opening protection sheet can be easily peeled from the container.

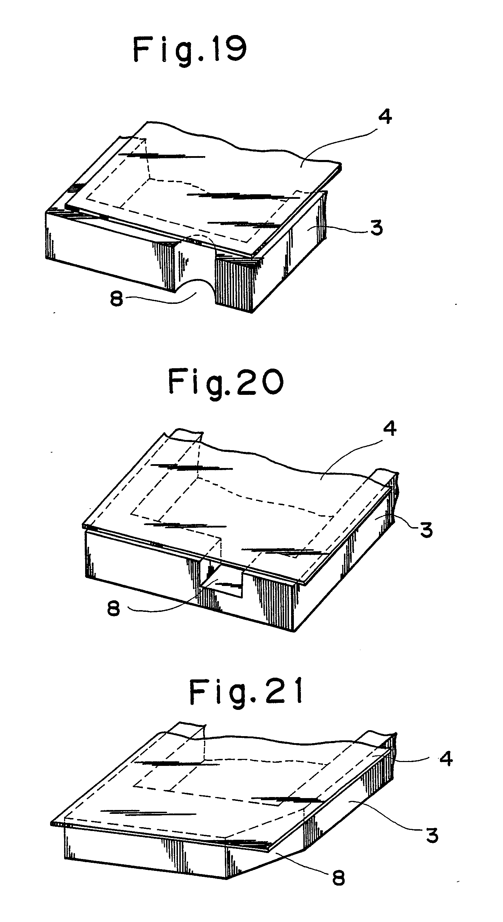

Figures 19, 20 and 21 are perspective views showing parts of 12th, 13th and 14th embodiments of containers provided with recesses for helping the removal of a protective sheet and an opening protection sheet from a container. As shown in Figure 19, a container 3 is formed in one side thereof with a semi-circular peel-assisting recess 8 for assisting the removal of a protective sheet, or an opening protection sheet 4. In the construction of Figure 20, a container 3 is formed in one side thereof with a square peel-assisting recess 8 for assisting the removal of a protective sheet or an opening protection sheet 4. In the construction of Figure 21, moreover, a container 3 is formed at one corner thereof with a peel-assisting cut-away portion 8 for assisting the removal of a protective sheet or an opening protection sheet 4. By providing a peel-assisting cut-away portion 8 in a container 3, a protective sheet 4 or an opening protection sheet 25 can easily be peeled from the container.

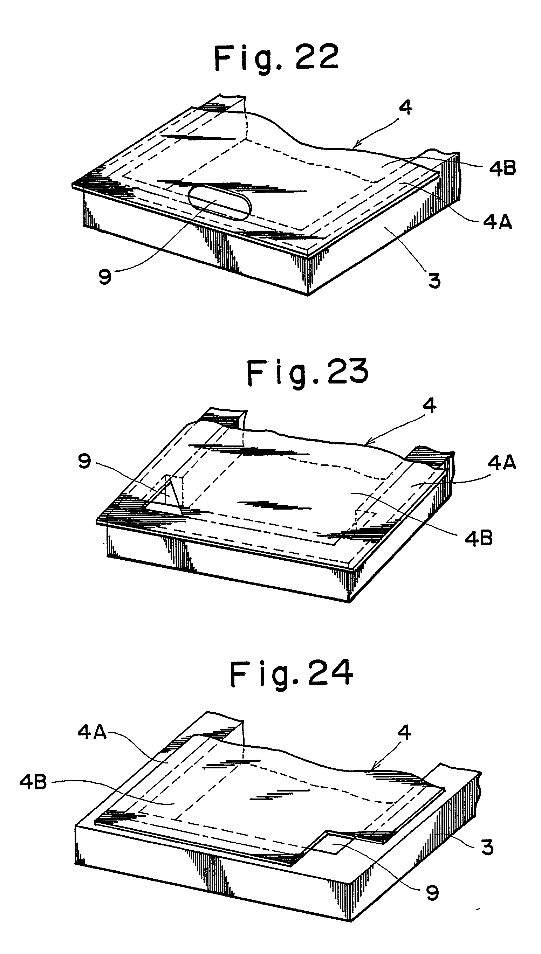

Figures 22, 23 and 24 respectively show 15th, 16th and 17th embodiments of the present invention which have a protective sheet or an opening protection sheet 4 having a manually engageable cut-out 9 provided therein. The cut-out 9 is helpful in removing from a container 3 a protective sheet or an opening protection sheet 4 having separating means such as perforations or the like. In a protective sheet or opening protection sheet 4 formed with separating means such as perforations along single-dotted lines for separating a sheet peeling portion 4B from a sheet fixing portion 4A as shown in Figure 22, a cut-out 9 in the form of an ellipse is provided. This cut-out, however, may be in forms such as a triangle as shown in Figure 23, a square as shown in Figure 24, etc. This type of cut-out may also be provided in a protection sheet or an opening protection sheet such as shown in Figure 1, Figure 2, Figure 13 or Figure 15A which is not provided with separating means such as perforations or the like.

In order to prevent double feeding of two or more image-recording sheets 1, a container 3 may be provided with double feed preventing members 2 such as those shown in Figure 2. It is possible for several image-recording sheets immediately under the topmost image-recording sheet stored in a container to be raised together with the topmost image-recording sheet when the latter is sucked up by the suckers at the feeding stage due to the vacuum attraction acting between the image-recording sheets. When the topmost image-recording sheet 1 is raised higher than the double feed preventing members 2, the opposite sides of the topmost image-recording sheet warp downward, and the sides of the image-recording sheets 1 sticking to the topmost image-recording sheet 1 are also warped. When the topmost image-recording sheet lifted up by the suction force of the suckers is further raised to a certain level, the sides of the topmost image-recording sheet 1 come off the double feed preventing members 2 and flip back due to their own elasticity, leaving the image-recording sheet(s) which have been sticking to the topmost image-recording sheet under the double feed preventing members 2, whereby the topmost image-recording sheet 1 is separated from the other image-recording sheet(s). The double feed preventing member may be made of a thin elastic material, and it can be formed in various shapes. As shown in Figure 2, double feed preventing members 2 may be tooth shaped.

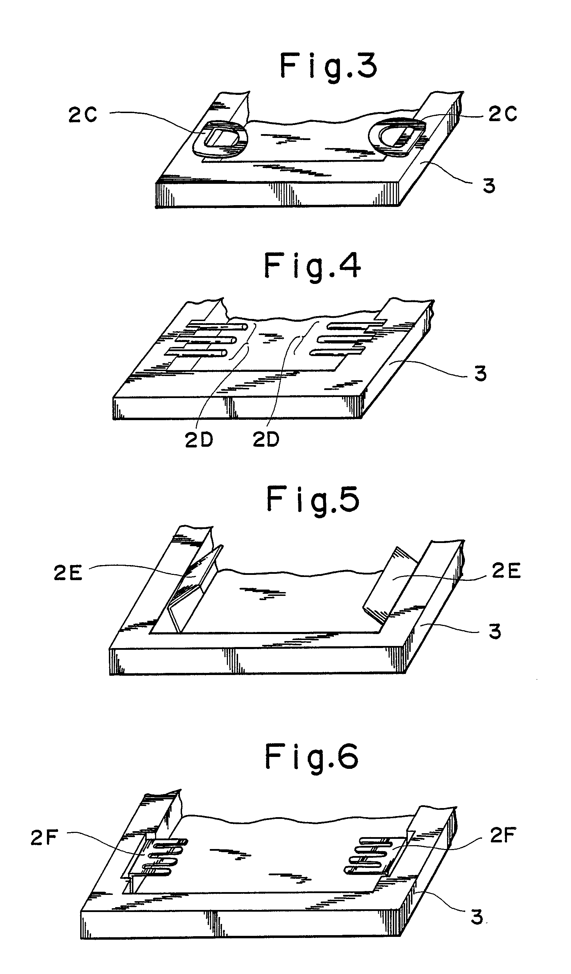

Another embodiment of the double feed preventing members 2 is shown in Figure 3. Figure 3 shows a construction in which ring-shaped double feed preventing members 2C are arranged on a container 3. As shown in Figure 4, thin round rods made of an elastic material are arranged in grooves formed in a container 3, to constitute double feed preventing members 2D. The rods to be used as the double feed preventing members 2D may be rectangular, and the number of rods employed may be at least one to prevent the double feed of the image recording sheets 1. The double feed preventing members 2, 2C and 2D thus far exemplified are arranged on the upper surfaces of the containers 3, but the members for preventing the double feed may be disposed at the inside storage portion of the container for storing the image recording sheets 1. Such embodiments are shown in Figures 5 and 6. Figure 5 shows a construction in which double feed preventing members 2E made of an elastic material such as a synthetic resin are arranged in the inside storage portion of a container 3E. Figure 6 shows a construction in which tooth-or comb-shaped double feed preventing members 2F are arranged in recesses formed in the inside storage portion of a container 3.

The foregoing double feed preventing members 2, 2C, 2D, 2E and 2F may take any shape if they could be warped when the image-recording sheets in the container are raised. A container and double feed preventing means may also be formed in one piece. Moreover, the double feed preventing members 2, 2C, 2D, 2E and 2F may also be disposed at the feeding (front) side of a container.

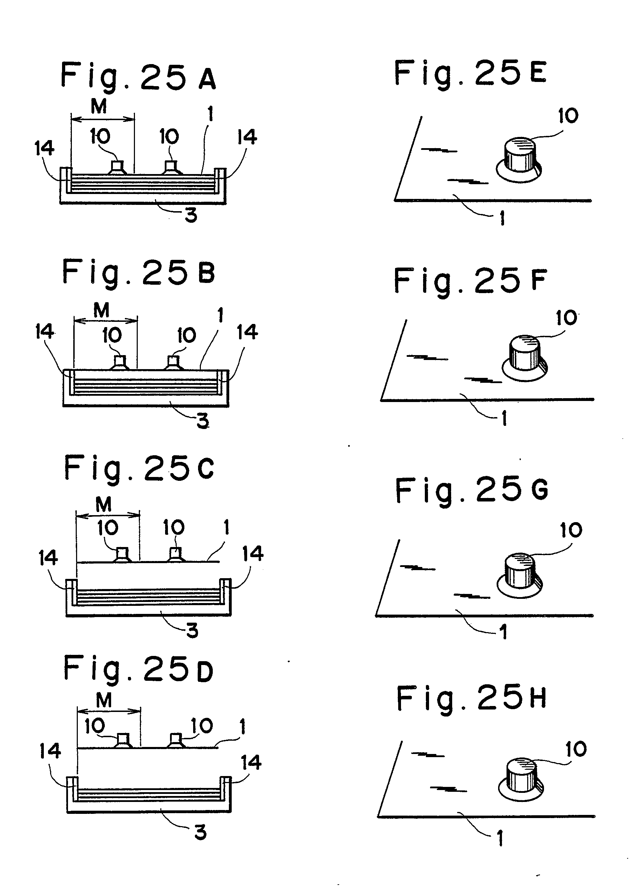

Figure 25(A) to Figure 25(D) are cross sections taken along the line G-G of the construction shown in Figure 11 which successively indicate the nature of the feeding operation of the image-recording sheets 1 by the suckers 10. Figure 25(E) to Figure 25(H) are perspective views showing a corner portion M of an image-recording sheet 1 where a sucker 10 is sucking up the image-recording sheet 1.

Image-recording sheets 1 are stored in a storage area 22 formed in the container 3. Double-dotted lines shown in Figure 11 show an imaginary level of the stored image-recording sheets 1. The storage space 22 has four corners formed with semi-elliptical recesses 14. By virtue of these recesses 14 at the corners of the storage space 22, the corners of an image-recording sheet 1 do not touch the corners of the storage space 22, which greatly reduces the friction between the corners of the image-recording sheet 1 and the corners of the storage space 22 when the image-recording sheet 1 is raised by the sucker, whereby feeding is greatly facilitated.

Figure 25(A) shows the state, in which the surface of the topmost image-recording sheet 1 stored in the container 3 is sucked up by the two suckers 10 of the paper feed device (not shown). Figure 25E is a perspective view showing the state of the image-recording sheet 1 which has been sucked up by the suckers 10 within the range of its M portion shown in Figure 25A. The end portion of the image-recording sheet 1 has a reduced contact resistance with respect to the container 3, particularly at its corners, because its contact ratio with the container 3 is reduced by the elliptical recesses 14 formed in the storage space 22, as shown in Figures 25B and 25F. As a result, the end portion of the image-recording sheet 1 is not caught up by the container 3 but is raised together with the suckers 10. Even if the suckers 10 are further raised, the image-recording sheet 1 is raised together out of the container 3, because the above-mentioned resistance is weaker than the attraction of the image-recording sheet 1 by the suckers 10. These states are consecutively shown in Figures 25C, 25G, 25D and 25H.

The image-recording sheet 1 carried out from the container 3 is fed to the inside of the image-recording apparatus by the paper feed device (not shown) so that an image is produced thereon. In the paper feed device used for describing the present embodiment, the image-recording sheet 1 is raised by the suckers 10, which may be replaced by suction pumps or the like.

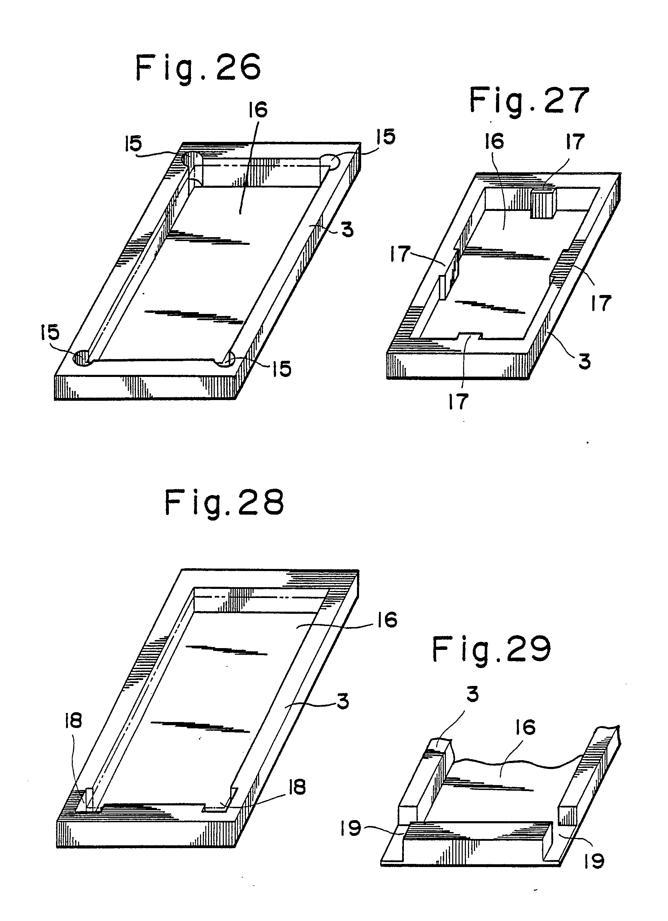

A container having corner recesses of another shape is shown in perspective in Figure 26. A container 3 is formed with circular recesses 15 at four corners of an inside storage shape 16 for storing the image-recording sheets 1. The state, in which the image-recording sheets 1 are stored in the inside storage shape 16, is shown by double-dotted lines. The circular recesses 15 are formed in the corners of the inside storage shape 16 at the corners of the image-recording sheets 1, so that the corners of the image-recording sheets 1 and of the container 3 will not contact each other. As a result, the contact resistance between the image-recording sheets 1 and the container 3 is weaker than the attraction of the suckers 10 of the paper feed device so that an image-recording sheet 1 can be easily carried out from the container 3.

A container having corner recesses of still yet another shape is shown in perspective in Figure 27. An inside storage shape 16 for storing the image recording sheets 1 is provided at each of its four sides with square projections 17, the corner recesses extending between adjacent projections 17.

The afore-mentioned recesses may be elliptical (e.g. the recesses 14 as shown in Figure 11) or circular (e.g. the recesses 15 as shown in Figure 26), but no problem will arise if the recesses are triangular, square or pentagonal. Moreover, the projections may be square (as in the case of the recesses 17 shown in Figure 27), and they may be curved into an elliptical or circular shape.

The inside storage shapes 6 and 16 so far described are shaped so that all the four corners of the image-recording sheets 1 are kept out of contact with the container 3. However, the inside storage shape may be made such that only two corners of the image-recording sheet 1 to be pulled up by the paper feed device are kept away from contact with the container. For example, Figure 28 is a perspective view showing a container having recesses only at two of its corners. An inside storage shape 16 for storing the image-recording sheets 1 is formed at the two corners with square recesses 18. Double-dotted lines shown in Figure 28 indicate a top level of the iamge-recording sheets 1 stored in the inside storage-space 16. Even if the square recesses 18 are formed only at the portions where the image recording sheet 1 is raised, no problem will arise in the paper feed.

Further, the recesses 18 may if desired have a circular shape.

All the containers so far described have their four side walls forming a continuous frame, but this frame may be notched at its corners to keep the corners of the image-recording sheets 1 away from contact with the container. For example, Figure 29 is a perspective view showing an essential portion of a container 3 having its corners cut away. A container 3 is formed at its corners with notches 19 so that the corner portions of the image-recording sheets 1 are kept away from contact with the container 3.

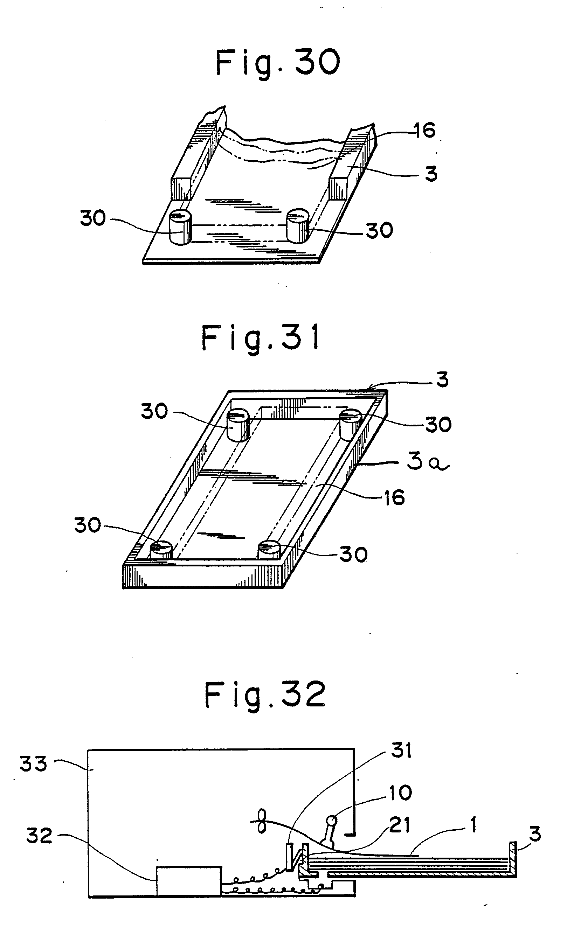

Moreover, the notches may be replaced by another structure in which the frame is partially removed from a container. For example, Figure 30 is a perspective view showing an essential portion of a container having a construction in which a part (one side) of the frame is not provided. The removed frame at one side thereof is replaced by two cylindrical members 30 which act to prevent the image-recording sheet 1 from coming out from the opening (i.e. the unframed side) of the container 3. The state, in which the image-recording sheet 1 is accommodated in an inside storage space 16, is indicated by double-dotted lines. Thus, a wide non-contact portion is established between the end portion of the image-recording sheet 1 and the container 3 so that the operations of the paper feed device are facilitated. The cylindrical members 30 need not be limited to two, and they may be square, triangular or elliptical in cross section.

Further, Figure 31 is a perspective view showing a container having four members 30 at its four corners. A container 3 has its four side walls 3a provided internally at its corners with cylindrical members 30 to define an inside storage space 16. The image-recording sheets 1 are housed, as indicated by double-dotted lines, in the inside storage shape 16 of the container 3 so that they are held between the members 30 and thus do not engage the long side walls of the container 3.

The shape of the image-recording sheets 1 so far described is rectangular, but similar effects can be achieved, even in the case of square or other shaped sheets 1 by using a container which has the aforementioned inside storage shape. Moreover, by combining the container and the inside storage shapes according to the above embodiments, the required non-contact between the end portions of the image-recording sheets and the container can be further improved.

Although the containers of Figures 26-31 are not shown as being provided with a protective sheet 4, this is merely for ease of illustration and it should be understood that these containers are in fact so provided.

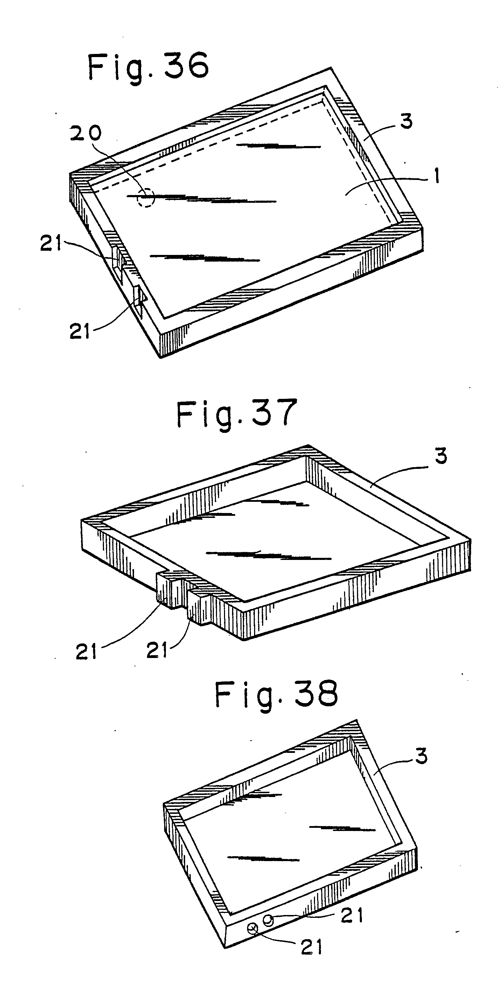

Figure 36 is a perspective view showing a container 3 provided with sheet size discriminating recesses 21 of a first type. Image-recording sheets 2, unlike ordinary paper, cannot be transported or handled by the operator's hands because their surfaces are coated with an image-forming agent. Therefore, the image-recording sheets 1 are packed in an image-recording sheet container 3. Thus, the image-recording sheets 1 can be protected from having their surfaces damaged and their printed image undergoing deterioration. The image-recording sheet container 3 is provided with sheet-size discriminating recesses 21 at one side wall thereof. The sheet size is indicated by the number and position of the sheet size discriminating recesses 21. In this embodiment, the sheet container 3 is so shaped that it can be directly mounted in an image-recording apparatus.

Figure 32 is a schematic section showing an image-recording sheet container 3 which is mounted in an image-recording apparatus 33. The image-recording sheet container 3 is mounted directly in the image-recording apparatus 33 by means of a holding means (not shown). The image-recording apparatus 33 is arranged with at least one non-contact type detector 31 in a position or positions corresponding to the sheet size discriminating recesses 21 at the side of the image-recording sheet container 3. The detector or detectors 31 are connected to a size discrimination unit 32.

In operation, the sheet size discriminating recesses 21 of the image-recording sheet container 3 are given different numbers and positions depending upon the sheet sizes so that the signals detected by the or each detector 31 are sent to the size discrimination unit 32 of the image-recording sheets 1 to discriminate between the sheet sizes. The image-recording sheets 1 are fed to the inside of the image-recording apparatus 33 by a paper feed unit 10 so that the size discrimination unit 32 operates the image-recording apparatus 33 in accordance with the sheet sizes.

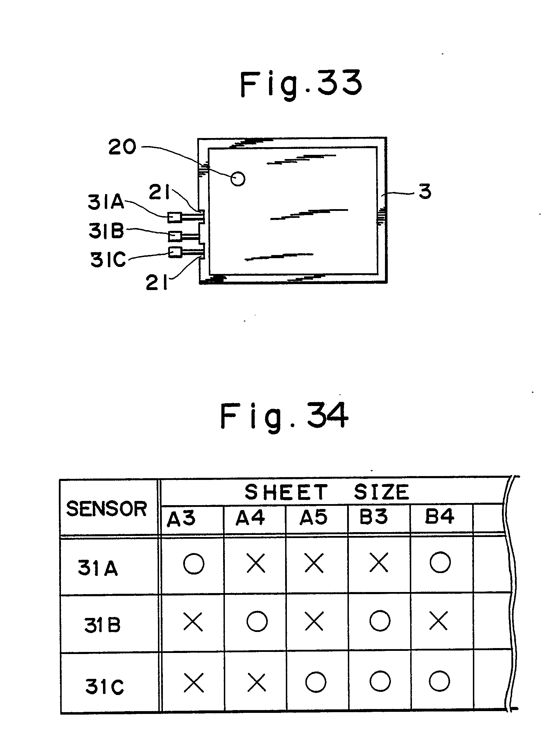

Figure 33 is a schematic top plan view showing the image-recording sheet container 3 and contact type detectors 31A, 31B, 31C. When the image-recording sheet container 3 is mounted in the image-recording apparatus 33, detectors 31A and 31C corresponding to the recesses of the sheet size discriminating recesses 21 are turned OFF whereas the detector 31B corresponding to the flat portion is turned ON. The detectors 31 detect the differences between the various sheet sizes by detecting the sheet size discriminating recesses 21 of the image recording sheet container 3. An arrangement for discriminating between the sheet sizes by combining the ON and OFF states of the detectors 31A, 31B and 31C is schematically illustrated in Figure 34. In Figure 34, circles indicate the ON states of the detectors 31A, 31B and 31C, and symbols X indicate the OFF states of the detectors. If the detector 31A is ON whereas the detectors 31B and 31C are OFF, for example, it is determined that the sheet size is A3. Further, for example, if the detectors 31A and 31C are OFF whereas the detector 31B is ON, it is determined that the sheet size at this time is A4. In the present embodiment, three detecors 31A, 31B and 31C are used, and therefore as many as eight different sheet sizes can be discriminated. If only two detectors are used, four different sheet sizes can be discriminated. Thus, the more detectors there are, the more sheet size discrimination is increased.

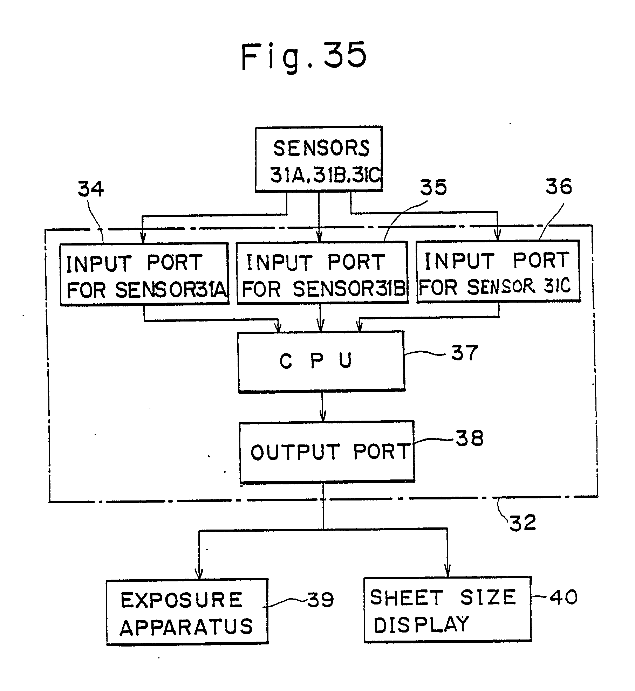

Figure 35 is a schematic block diagram showing the operating procedures of the size discrimiantion unit 32 for the image-recording sheets 1, which is used in the embodiment shown in Figure 36. The signals detected by the detectors 31A, 31B and 31C are fed to input ports 34, 35 and 36 in the size discrimination unit 32. The signals are further fed from the individual input ports to a CPU 37 which is stored with data of the sheet sizes to discriminate between the image-recording sheets 1 placed in the image-recording apparatus 33. Next, the discriminated data are transmitted from an output port 38 to an exposure apparatus 39 to make the image-recording operations possible and further to a sheet size display 40 to display the sheet size.

Figure 38 is a perspective view showing an image-recording sheet container provided with sheet size discriminating recesses 21 of a further type. As shown in the Figure, the image-recording sheet container 3 is formed in a side wall thereof with circular sheet size discriminating recesses 21.

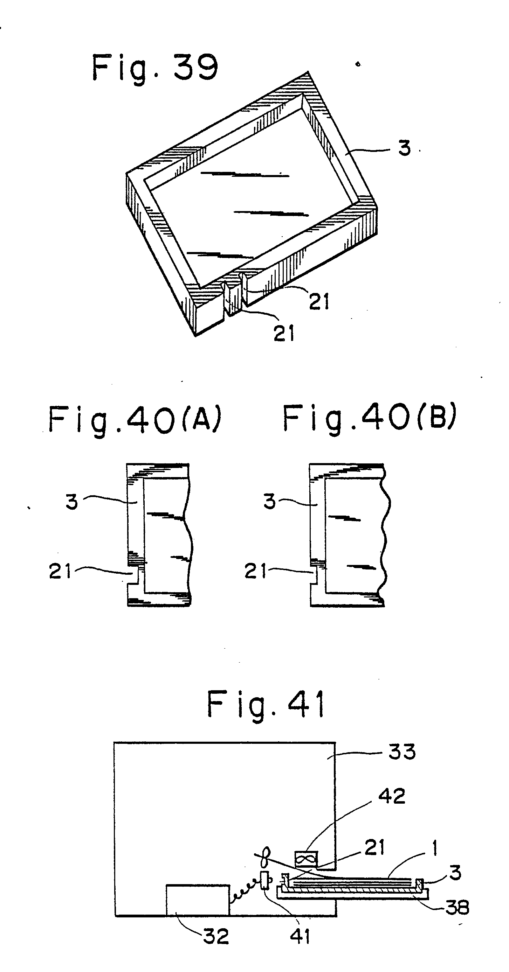

Figure 39 is a perspective view showing an image-recording sheet container having sheet size discriminating recesses of a yet further type. The image-recording sheet container 3 is in this case formed in a side wall thereof with sheet size discriminating notches 21.

Figure 37 is a perspective view showing an image-recording sheet container having sheet size discriminating blocks of a still further type. As shown, the image-recording sheet container 3 is formed in a side wall thereof with protruding sheet size discriminating parts 21.

The sheet size discriminating members may also, if desired be polygonal or elliptical. Moreover,the members may be hollow, recesses or protruded.

Figures 40A and 40B are partial, schematic top plan views showing other types of sheet size discriminating members which may be used. The image-recording sheet containers 3 are provided therein with recesses having depths which differ according to the sheet sizes. The sheet size discriminating member 21 shown in Figure 40A is deeper than the sheet size discriminating member 21 shown in Figure 40B.

Although the containers of Figures 36-39, 40A, 40B and 46A are not shown as being provided with a protective sheet 4, this is merely for ease of illustration and it should be understood that these containers are in fact so provided.

Figure 41 is a schematic cross section showing an image-recording sheet container according to the present invention mounted in an image-recording apparatus 33. The image-recording apparatus 33 is provided at its paper receiving portion with a case bed 38 holding an image-recording sheet container 3 housing image-recording sheets 1. The case bed 38 is shaped to surround the image-recording sheet container 3 so as to hold the image-recording sheet container 3 in a fixed position. In a position of the image-recording apparatus 33 corresponding to the sheet size discriminating members 21 of the image-recording sheet container 3, there is provided a non-contact type detector 41 such as an ultrasonic transmitter or a microphone for measuring the depth of the sheet size discriminating members 21.

When the image-recording sheet container 3 containing the image-recording sheets 1 is mounted on the bed 38, the detector 41 detects the depth of the recesses of the sheet size discriminating members 21 so that a signal is sent to the size discrimination unit 32 to indicate the sheet size. The operating procedure of the size discrimination unit 32 is similar to that shown in Figure 35 except for the detector 41, and therefore its explanation is omitted here. The image-recording sheets 1 are sucked up by a suction unit 42 and conveyed to the inside of the image-recording apparatus 33 by a feeding mechanism (not shown). Although a non-contact detector 41 is used for measuring the depth of the sheet size discriminating members 21 in the present embodiment, a mechanical contact detector can also be used if desired. For example, a detector using a linear potentiometer or a link means can be used to produce signals corresponding to the depth of the sheet size discriminating members 21 formed in the image recording sheet container 3.

As shown in Figure 11, an image-recording sheet container 3 is formed in its bottom with a circular recognition hole 20 for permitting the existence of image-recording sheets 1 in the container 3 to be recognised. When image-recording sheets 1 are left in the container 3, the recognition hole 20 is covered by the remaining image recording sheets 1. On the other hand, the hole 20 is open when the image-recording sheets 1 are exhausted.

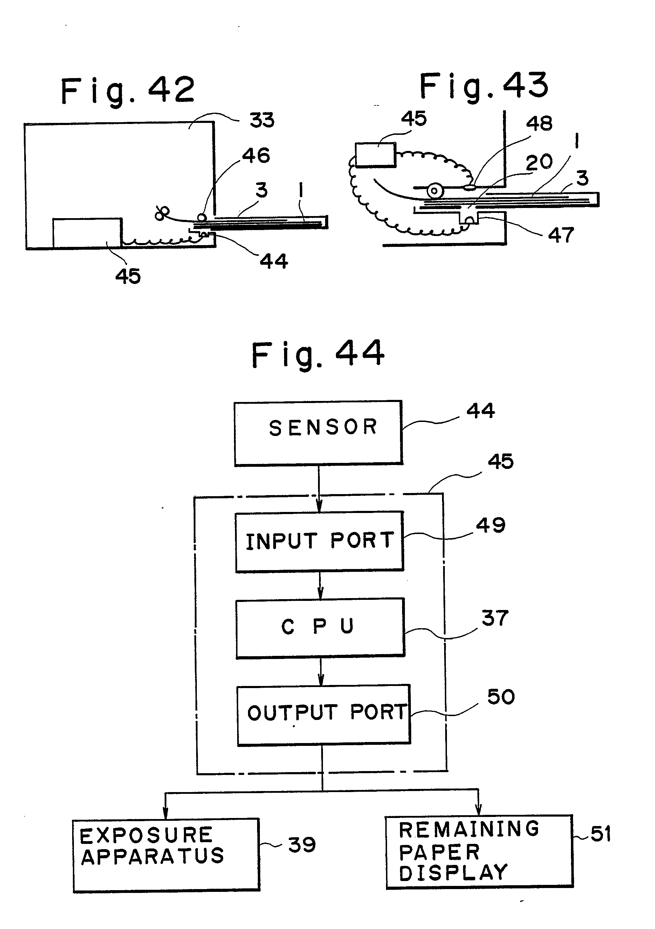

Figure 42 is a schematic view showing the image-recording sheet container 3 of Figure 11 mounted in an image-recording apparatus 33. The image-recording sheet container 3 is mounted in the image-recording apparatus by means of a holding mechanism (not shown). In the image-recording apparatus 33, there is fixed a non-contact, reflection type exhaustion sensor 44 which is positioned to correspond to the recognition hole 20 in the bottom of the image-recording sheet container 3, the sensor 44 being a reflection type photo sensor. The reflection type exhaustion sensor 44 is connected to an exhaustion discrimination unit 45 for the image-recording sheets 1.

While the image-recording sheets 1 are present, the recognition hole 20 is covered by an image-recording sheet 1 so that a signal detected by the exhaustion sensor 44 is sent to the existence discrimination unit 45 to determine that at least one image-recording sheet 1 is present. After the presence of the image-recording sheet 1 has been confirmed by the existence discrimination unit 45, the image-recording apparatus 33 is ordinarily operated to feed out any image-recording sheets 1 to the inside of the image-recording apparatus 33 by the action of a roller 46 of the paper feed unit. When the image-recording sheets 1 are exhausted, the recognition hole 20 is opened so that the existence sensor 44 sends a signal indicating the exhaustion of the image-recording sheets 1 to the exhaustion discrimination unit 45. Then, this unit 45 sends a signal to an operating mechanism of the image-recording apparatus 33 to stop its operations.

Figure 44 is a schematic diagram illustrating the operation of the exhaustion discrimination unit 45. The signal produced by the existence sensor 44 is sent to an input port 49 in the exhaustion discrimination unit 45. Then, the data from the input port is sent to a CPU 37 stored with operation data indicating the existnece of the image-recording sheets 1, to determine whether there are image recording sheets 1 in the image-recording sheet container 3 placed in the image-recording apparatus 33. Next, the discrimination data is transmitted from an output port 50 to an exposure apparatus 39 to maintain the image-recording operation during the presence of image-recording sheets, and to make it impossible in the absence of image-recording sheets. The discrimination data is further sent to a remaining paper display 51 so that the presence or absence of the image-recording sheets 1 is displayed on a display panel.

Figure 42 shows an embodiment using a reflection type photo sensor, and Figure 43 shows an embodiment using an interrupter type photo sensor 47 and 48. In the latter case, a light receiving sensor 48 is positioned above the recognition hole 20. The operation of determining the presence or exhaustion of the image-recording sheets 1 is identical to that of Figure 42, and will therefore be omitted here.

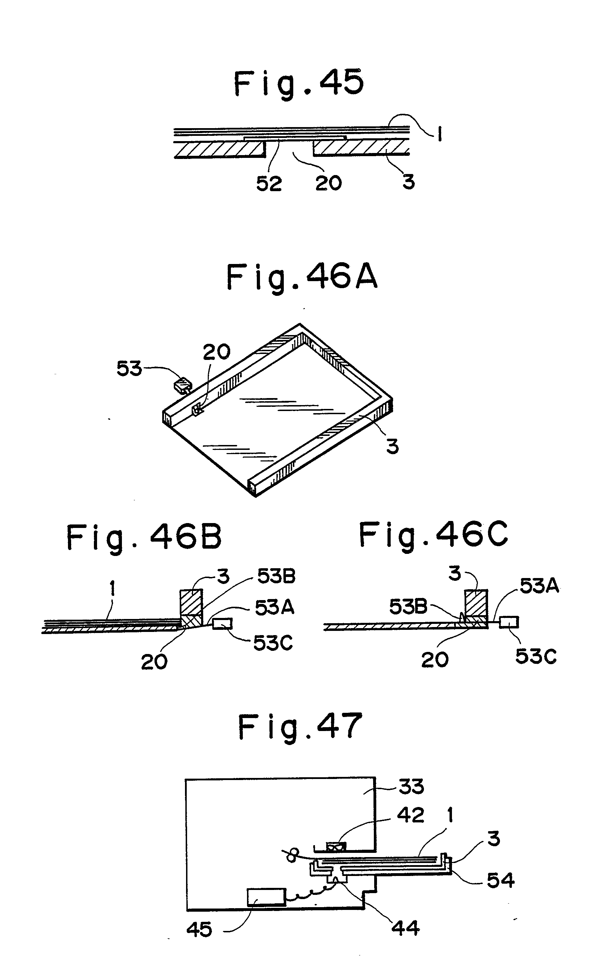

Figure 45 is an enlarged section showing another image-recording sheet recognition hole 20. A transparent film 52 such as cellophane is fixed over a recognition hole 20 and is disposed within the container 3 so that the sheets 1 can be prevented from being damaged from the outside of the image-recording sheet container 3. By the use of the transparent film 52, it is possible to use the reflection or transmission type photo sensor as in the previous embodiments. On the other hand, the film 52 can alternatively be disposed for similar effects on the outer side of the image-recording sheet container 3. Alternatively, the face of the image-recording sheet container 3, at which the image-recording sheets 1 come into contact, can be made of a transparent member.

In the embodiment shown in Figure 45, not only the size of the sheets 1 can be automatically recognized, but also the size of the sheets which have been supplied to the image-recording apparatus can be recognized by changing the colour of the film 52 to indicate the individual sheet sizes and by providing individual colour recognition sensors.

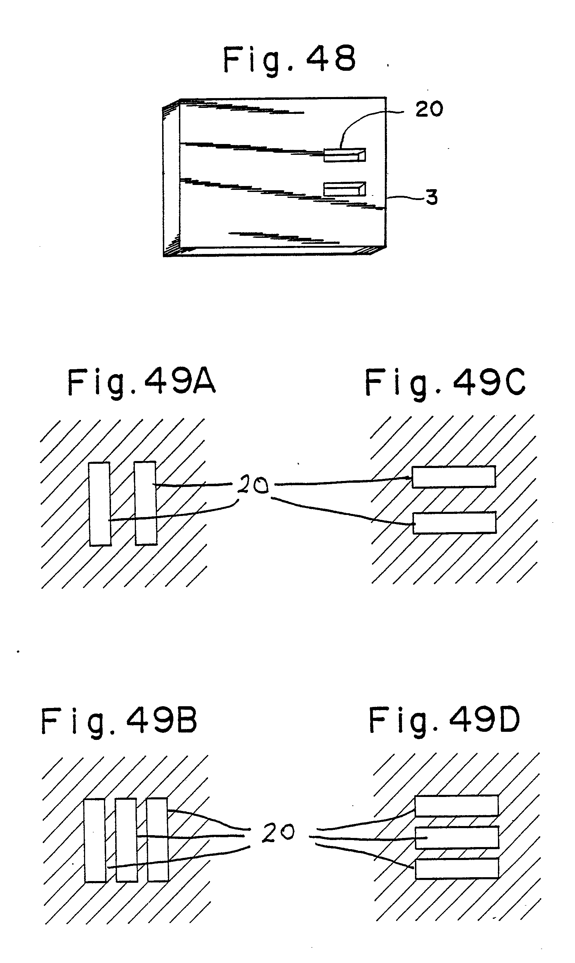

Another means for recognizing the sheet sizes is shown in Figure 48. Figure 48 is a perspective view showing the back of an image-recording sheet container 3. The container 3 is blackened at its back. Discriminating holes 20 in the bottom of the container 3 are schematically shown in Figures 49A to 49D. The discriminating holes 20 shown in Figure 49A, Figure 49B, Figure 49C and Figure 49D may, for example, correspond to image-recording sheet sizes of A4, A3, B4 and B5 sizes respectively. The sizes of the image-recording sheets 1 can be determined by arranging the sensor provided below the discriminating holes 20 to recognize the discriminating holes 20 by reflection or the like. No reflection can come from the image-recording sheets 1 when the latter are exhausted, and this provides an indication of their presence or exhaustion. Since the paper of the sheets 1 is usually white, the discrimination power is improved by colouring the walls or areas around the discriminating holes 21 black or some other dark colour. It should be noted that the discriminating holes 21 may have any shapes provided that they are different for the different sizes. It is apparent that only an area around the discriminating holes 20 need be coloured black in order to obtain the same result. The presence and sizes of the sheets 1 can be recognized by the use of a single recognition hole. It should also be noted that, although the recognition hole 20 is circular in the embodiments shown above, it may be polygonal or elliptical. The existence of the image-recording sheets 1 can naturally be detected even if the image-recording sheet container 3 has its side formed with a similar recognition hole or notch, as will now be described.

As shown in Figure 46A, an image-recording sheet container 3 has its side formed partially in its lower portion with a recognition hole 20 of the image-recording sheets 1. A touch sensor 53 comprising a micro-switch or the like is fixed on the paper feed unit (not shown) of the image-recording apparatus. If the image-recording sheet container 3 is mounted in the image-recording apparatus, as is more specifically shown in Figures 46B and 46C, the touch sensor 53 disposed in the image-recording apparatus is brought to the position of the recognition hole 20 of the image recording sheet packing case 20 by means not shown. Figure 46B shows the case in which the image-recording sheets 1 are present so that the touch sensor 53 is turned OFF, for example, by the weight of the image-recording sheet 1. Figure 46C shows the case, in which the image-recording sheets 1 are exhausted so that the touch sensor 53 is turned ON, for example. Here, the touch sensor 53 is provided at one end of a leaf spring 53A with a projection 53B, which comes into contact with the lower side of the image-recording sheets 1. The other end of the leaf spring 53A is connected to a switch 53C which is turned ON and OFF in accordance with the vertical motions of the leaf spring 53A to determine the presence or absence of the image-recording sheets 1.

The image-recording sheet container 3 used in the above embodiment is shown as having only three sides. However, it may have all four sides if desired.

Further, in the above embodiment, the image-recording sheet container 3 is so made that it can be placed directly in the image-recording apparatus. However, a container containing the image-recording sheets 1 may be mounted on a container tray which is attached to the image-recording apparatus. This embodiment is shown in a schematic section in Figure 47. At the paper-receiving portion of an image-recording apparatus 33, there is arranged a container tray 54, on which is mounted an image-recording sheet container 3 holding the image-recording sheets 1. The container tray 54 is placed over an existence sensor 44 which is made of a reflection type photo sensor for detecting the existence of the image-recording sheets 1. If the image-recording sheets 1 are present, they are sucked up by a suction unit 42 and are conveyed to the inside of the image-recording apparatus by the action of means, not shown.

The image-recording sheets 1 used in the present embodiment have their surfaces coated with image-forming substances, but even ordinary paper having no coating of image-forming material may be used. Moreover, although the protective sheets, peeling-away aids provided on the protective sheets, double feed preventing members, corner recesses provided in containers, sheet size recognition means, and sheet exhaustion discriminating means have been described separately in the foregoing paragraphs, they may be combined to provide an image-recording sheet container which provides optimum feeding characteristics for a given feeding mechanism of an image-recording apparatus.

## Claims

1. A container (3) for holding image-recording sheets (1) used in the image-recording apparatus, the container (3) having side walls (3a) and a bottom wall (3b) defining a space (3c) for holding image-recording sheets (1) characterised in that the top of the container (3) is provided with protective sheet means (4) adapted to cover at least part of any said sheets (1) in said space (3c).

2. A container (3) as claimed in claim 1 characterised in that the protective sheet means (4) are adapted to protect any said sheets (1) in said space (3c) from physical contact prior to use in the said apparatus, at least a part of the protective sheet means (4) being readily removable from the container (3) to permit any said sheets (1) therein to be fed to the said apparatus.

3. A container (3) as claimed in claim 2 characterised in that at least part of the protective sheet means (4) can be peeled away from the container (3).

4. A container (3) as claimed in claim 3 characterised in that there are means (5,9) for assisting the said peeling away of the protective sheet means (4).

5. A container (3) as claimed in claim 4 characterised in that the protective sheet means (4) has a portion (5) which extends outwardly of the adjacent part of the container (3) so as to assist the said peeling away of the protective sheet means (4).

6. A container (3) as claimed in claim 4 characterised in that the protective sheet means (4) is provided with a cut-out (9).

7. A container (3) as claimed in any of claims 3-6 characterised in that the protective sheet means comprises a part (25) which is adapted to be at least partially peeled away from the container (3) and a part (4) which is adapted to remain fixed to the container (3).

8. A container (3) as claimed in any preceding claim characterised in that the top of the container (3) is provided with a removable protective sheet (24) which overlies the protective sheet means (4) and may be removed from the latter.

9. A container (3) as claimed in any preceding claim characterised in that a stack of image-recording sheets (1) are housed in said space (3c), each said sheet (1) comprising a substrate coated with an image-forming agent which is reactive with a photosensitive material.

10. A container (3) as claimed in any preceding claim characterised in that the container (3) is provided with means (2) for preventing or reducing double feeding of image-recording sheets (1) from the container (3).

11. A container (3) as claimed in claim 10 characterised in that side walls of the container (3) have parts (15,18,19) which are cut away with respect to other parts thereof so that corner portions of image-recording sheets in the said space do not engage said cut away parts (15,18,19).

12. A container (3) as claimed in claim 10 characterised in that the container (3) has sheet-engaging members (30) therein to prevent engagement between at least part of side walls (30) of the container and adjacent sides of the said sheets (1).

13. A container (3) as claimed in any preceding claim characterised in that the container (3) is provided with indicating means (21) for indicating the size of the image-recording sheets (1) which it is adapted to hold.

14. A container (3) as claimed in claim 13 characterised in that the indicating means (21) comprises at least one recess or projection in a side wall of the container (3).

15. An image-forming apparatus characterised in that it is provided with a container (3) as claimed in any preceding claim, feeding means (10-13) being provided for feeding image-recording sheets (1) from the container (3) to the apparatus.

16. An image-forming apparatus as claimed in claim 15 characterised in that recognition means (20,44,45) are provided for recognizing the presence or exhaustion and/or the size of image-recording sheets (1) in the container (3).

17. An image-forming apparatus as claimed in claim 16 characterised in that the recognition means (20,44,45) comprises a non-contact type sensor (44).

18. An image-forming apparatus as claimed in claim 17 characterised in that the sensor (44) is responsive to light passing through a hole (20) in the bottom wall of the container (3).

19. An image-forming apparatus as claimed in claim 16 characterised in that the recognition means (20,44,45) comprises a contact type sensor.

20. An image-forming apparatus as claimed in claim 19 in which the contact type sensor is a micro- switch or a potentiometer.

21. A container (3) for holding image-recording sheets (1) used in an image-recording apparatus characterised in that the container (3) is provided with means (2) for preventing or reducing double feeding of image-recording sheets (1) from the container (3).

22. A container (3) for holding image-recording sheets (1) used in an image-recording apparatus characterised in that the container (3) is provided with indicating means (21) for indicating the size of the image-recording sheets (1) which it is adapted to hold.

23. An image-forming apparatus characterised in that recognition means (20,44,,45) are provided for recognizing the presence or exhaustion and/or the size of image-recording sheets (1) in the container (3).

24. A packing case for accommodating image-recording sheets (1) used in an image recording apparatus:

comprising sides (3a) and a bottom (3b) defining a space for accommodating image-recording sheets (1); and

a protective sheet (4) covering the image-recording sheets (1) for the protection thereof.

25. An image forming apparatus for forming an image on a image recording sheet comprising:

feeding means for feeding an image recording sheet into said image forming apparatus;

illuminating means for illuminating an original;

exposure means for exposing said image recording sheet to light representative of the original; and

a packing case for accommodating image recording sheets used for said image recording apparatus, characterised in that said packing case comprises sides and a bottom defining a space for accommodating image recording sheets; and

a protective sheet covering image recording sheets for the protection thereof.

# Fig.1

3b  3c  /  3a  3  4

# Fig.2

2  4  2  3

# Fig.3

# Fig.4

# Fig.5

# Fig.6

Fig.7

Fig.8

## Fig.9

## Fig.10A

## Fig.10B

# Fig.11

# Fig.12

Fig.13

Fig.14

Fig.15A

Fig.15B

25

4

3

Fig.16A

4B

4A

4

3

Fig.16B

4B

4A

3

# Fig.16C

# Fig.17

# Fig 18

# Fig.19

# Fig.20

# Fig.21

# Fig. 22

# Fig. 23

# Fig. 24

# Fig. 25 A

# Fig. 25 B

# Fig. 25 C

# Fig. 25 D

# Fig. 25 E

# Fig. 25 F

# Fig. 25 G

# Fig. 25 H

Fig.26

Fig.27

Fig.28

Fig.29

# Fig. 30

# Fig. 31

# Fig. 32

# Fig.33

20

21

31A

31B

31C

21

3

# Fig.34

| SENSOR | SHEET SIZE | | | | | |
|--------|-----|-----|-----|-----|-----|---|
|  | A3 | A4 | A5 | B3 | B4 | |
| 31A | ◯ | ✕ | ✕ | ✕ | ◯ | |
| 31B | ✕ | ◯ | ✕ | ◯ | ✕ | |
| 31C | ✕ | ✕ | ◯ | ◯ | ◯ | |

# Fig.35

# Fig.36

# Fig.37

# Fig.38

# Fig. 39

# Fig.40(A)    Fig.40(B)

# Fig.41

# Fig. 42

# Fig. 43

# Fig. 44

SENSOR — 44

INPUT PORT — 49

C P U — 37

OUTPUT PORT — 50

EXPOSURE APPARATUS — 39

REMAINING PAPER DISPLAY — 51

# Fig.45

52 20 3 1

# Fig.46A

53 20 3

# Fig.46B

1 3 53B
53A
20 53C

# Fig.46C

3 53A
53B
20 53C

# Fig.47

33
42 1
3
54
45 44

# Fig. 48

# Fig. 49A

# Fig. 49B

# Fig. 49C

# Fig. 49D

# Fig.50
## PRIOR ART

61    60

# Fig.52
## PRIOR ART

65D
66
65C
65
65A
65B
64    61
60
62
63

# Fig.51
## PRIOR ART

### Fig.51 A

K
16 · 10 · 10 · 1
3

### Fig.51 B

K
16 · 10 · 10 · 1
3

### Fig.51 C

K
16 · 10 · 10 · 1
3

### Fig.51 D

K
16 · 10 · 10 · 1
3

### Fig.51 E

10
1

### Fig.51 F

10
1 · 1A
L

### Fig.51 G

10
1
L · R
1A

### Fig.51 H

10
1A · 1